# EUROPEAN PATENT SPECIFICATION

(11) **EP 0 557 081 B1**
(45) Date of publication and mention of the grant of the patent: **24.04.1996**
(21) Application number: 93301168.6
(22) Date of filing: 16.02.1993
(51) Int. Cl.: H05K 3/34, H01R 9/09

(54) **Printed circuit board**
Leiterplatte
Circuit imprimé

(30) Priority: 17.02.1992 JP 6211/92 U
(43) Date of publication of application: 25.08.1993
(73) Proprietor: CONNECTOR SYSTEMS TECHNOLOGY N.V., Willemstad Curaçao (AN)
(72) Inventor: Lee, Chen Wen c/o Du Pont Taiwan LTD, Chung-Li (TW); Chang, Fong Pei c/o Du Pont Taiwan LTD, Chung-Li (TW); Chen, Chou Lin c/o Du Pont Taiwan LTD, Chung-Li (TW)
(74) Representative: Barnard, Eric Edward

(56) References cited:
- US-A- 4 132 341
- US-A- 4 303 291
- PATENT ABSTRACTS OF JAPAN vol. 16, no. 27 (E-1158)23 January 1992 & JP-A-32 41 888
- PATENT ABSTRACTS OF JAPAN vol. 13, no. 176 (E-749)25 April 1989 & JP-A-10 05 096

## Description

The present invention relates to a printed circuit board and, in particular, to a connector-mount type printed circuit board.

In a connector-mount printed circuit board the contacts of the connector are each mounted on a solder pad provided over the printed circuit board or the contacts of the connector are each inserted into a corresponding through hole provided in the printed circuit board. That circuit pattern and contacts are soldered for electrical connection.

Aligning a greater number of contacts accurately with solder pads or through holes prior to a soldering step involves a complex, delicate operation and hence reduces operation efficiency.

Upon the soldering of the contacts of the connector to the circuit pattern, the contacts are sometimes liable to be soldered to a location misaligned with the solder pad, or cannot be uniformly joined by a soldering step at all times, because the contact is temporarily not set relative to the solder pad. Further, a bridge is sometimes created across those adjacent contacts due to the deposition of excessive solder, thus short-circuiting the contact involved.

Such a misalignment and short-circuiting occur prominently in those cases, in particular, where the pitch of adjacent contacts is finely set. It is accordingly the object of the present invention to provide a printed circuit board which can readily set contacts in an aligned relation, upon soldering, and ensure a simpler soldering operation for terminal electrical connection without creating any solder bridge or bridges.

It is known from US-A-4303291 and from JP-A-3241888 (Patent Abstracts of Japan Vol. 16 No. 27) to provide a solder mask layer resistant to solder over a printed circuit pattern layer on a printed circuit board and to remove regions of the solder mask layer to expose solder pads for connection to contacts of a connector.

As is known from US-A-4303291, the present invention provides a printed circuit board for electrically connecting to a connector having a plurality of contacts comprising:
a laminated board;
a conductive printed circuit pattern layer provided over a surface of the laminated board, said circuit pattern layer also defining a plurality of separate solder pads intended for soldering to the contacts and
a solder mask layer partly covering the circuit pattern layer and the solder pads.

In contrast to US-A-4303291, and in accordance with the present invention, the solder mark layer has openings facing an edge of the board and corresponding to the solder pads to create exposed portions of the solder pads and the solder mask layer covers all the edge surfaces of the solder pads except for the edge surfaces adjacent the edge of the board and the exposed portions of the solder pads alternate with portions of the solder mask layer, along said one edge of said laminated board.

The exposed portions of the solder pads may include a plurality of connection land portions intended to be soldered to a corresponding contact or solder tail with the contact placed on the exposed portion of the connection land portion.

Upon the soldering of the contacts of the connector to the exposed portions of the connection land portions of the solder pads of the printed circuit board, molten solder is dammed up by the inner wall of the solder mask layer interposed between adjacent land portions thus preventing any solder bridge or bridges from being created across the adjacent land portion.

As the printed circuit board is opened at the one edge, when the contacts are positioned relative to connection land portions prior to the soldering step, the inner wall of the solder mask layer defining the exposed areas of the connection land portions serves as a guide for guiding the contacts onto the connection land portions.

This invention can be more fully understood from the following detailed description when taken in conjunction with the accompanying drawings, in which
Fig. 1 is a perspective view showing part of a printed circuit board according to one embodiment of the present invention;
Fig. 2 is a top view showing the printed circuit board before their mounting together with a connector is performed;
Fig. 3 is a cross-sectional view as taken along line III - III in Fig. 2;
Fig. 4 is a top view showing U-shaped openings or recesses and connection land portions for a staggered array of solder tails;
Fig. 5 is a top view showing U-shaped openings or recesses and connection land portions for a single array of solder tails;
Fig. 6 is a cross-sectional view showing solder pads and solder tails before a reflow soldering method is carried out;
Fig. 7 is a cross-sectional view showing the solder pads and solder tails after the reflow soldering method is carried out; and
Fig. 8 is a cross-sectional view showing a solder pad and solder tail soldered together by a hand soldering operation.

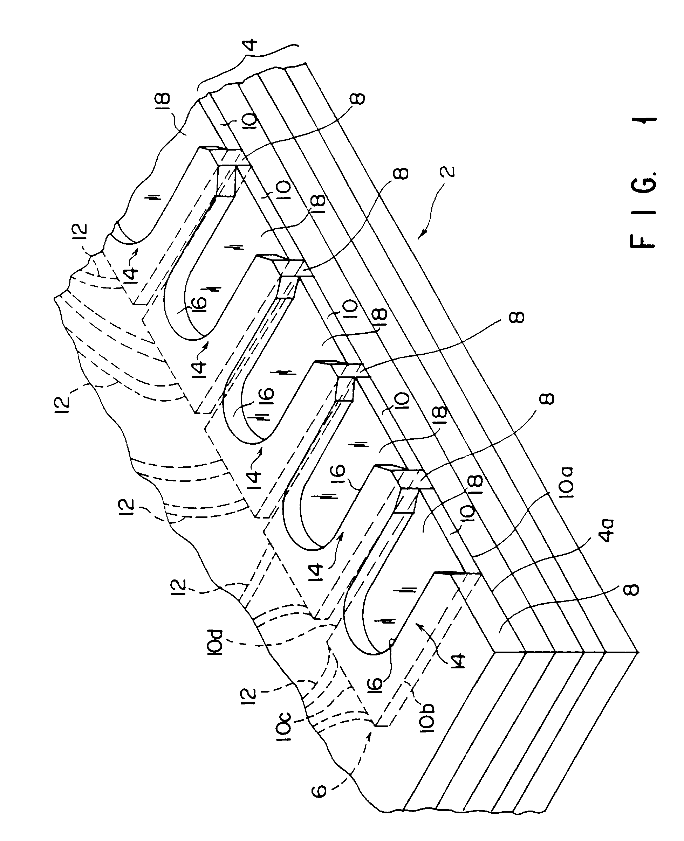

Figs. 1 to 3 show a printed circuit board according to an embodiment of the present invention.

The printed circuit board 2 comprises a laminated board 4, a printed circuit pattern layer 6 and a solder mask layer 3 which are sequentially stacked in that order. A connector (not shown) such as a receptacle connector or a header connector with contacts is connected to the printed circuit board 2.

The circuit pattern layer 6 is formed of a conductive metal, usually copper, and has solder pads 10 arranged relative to planar connection land portions and a circuit pattern 12. The solder pads 10 are arranged along one edge 4a of the surface of the laminated board 4. One of four edge surfaces 10a, 10b, 10c and 10d of the respective solder pad 10 is situated adjacent the edge 4a of the laminated board 4. The width of each solder pad 10 in an array direction of the soldered pads 10 is about two times or more of a solder tail of a corresponding connector to be connected. The surface of the solder pad 10 is tin-plated.

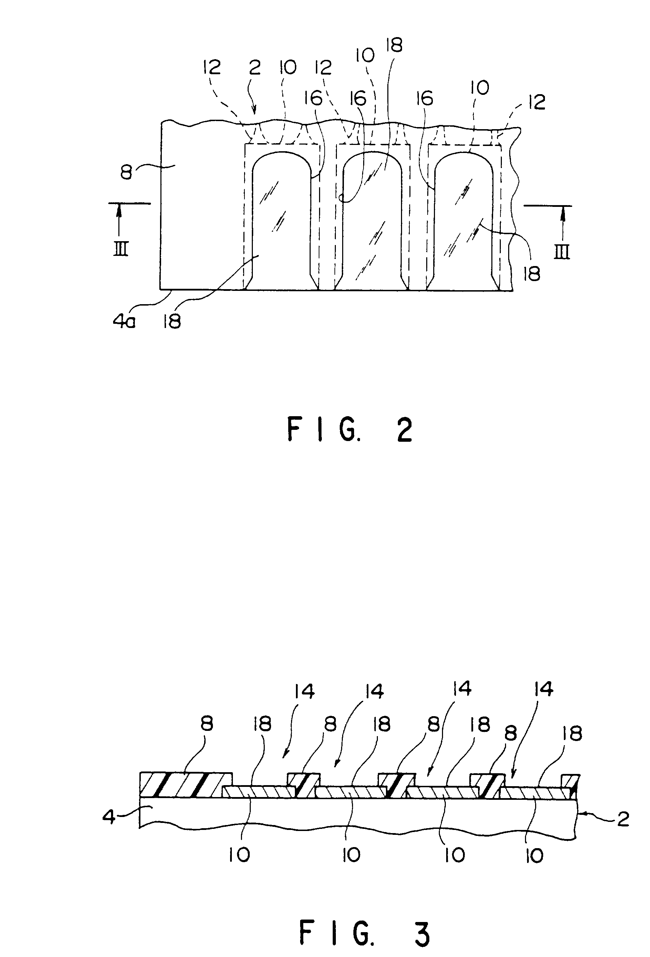

The solder mask layer 8 is formed of a dry film solder mask made of, for example, an ultraviolet radiation hardening type photopolymer or a solder resist layer. The solder mask layer 8 partly covers the surface of the circuit pattern layer 6. As shown in Fig. 2 in particular, the solder mask layer 8 has a U-shaped opening in the form of a chamfer or recess 14 at an area of each of the solder pads 10. The U-shaped openings 14 serve as guides for guiding contacts of the connector.

The planar configuration of each U-shaped opening 14 is defined by an inner wall 16 of the solder mask layer 8 on the surface of the solder pad 10 and the edge surface 10a which is not covered by each solder mask layer 8. The inner wall 16 of the U-shaped opening 14 covers the three edge surfaces 10b to 10d of the associated solder pad 10. The inner wall 16 of each U-shaped opening 14 serves as a solder dam for preventing molten solder from flowing from the U-shaped opening 14.

The surface of the solder pad 10 defining the bottom of the U-shaped opening 14 provides an exposed surface portion 18 not covered with the solder mask layer 8.

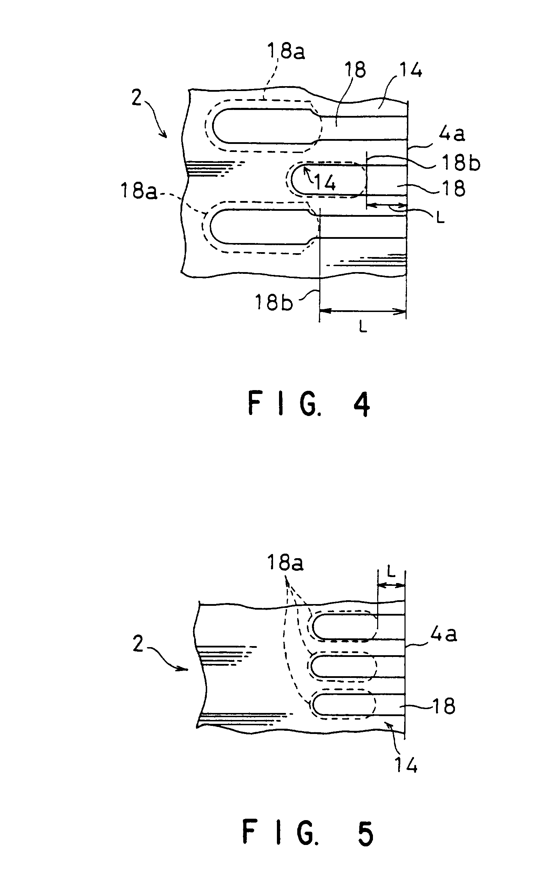

As shown in Fig. 3, the solder mask layer 8 and solder pad exposed portions 18 are alternately arranged, in a stepped relation, along the edge 4a of the laminated board 4.

Figs. 4 and 5 show alternative dispositions for the connection land portions 18a, that is, the areas where parts of the contacts (the solder tails) of the connector are to be soldered to the surface portions 18 of the solder pads 10. The connection land portions 18a correspond to the solder pad exposed portions 18 at a surrounded area indicated by the dotted line.

In Fig. 4 the connection land portions 18a have their edges 18b situated at one of two predetermined distances L from the edge 4a of the laminated board 4. In Fig. 5, the connection land portions 18a are all disposed at the same distance L from the edge 4a of the laminated board 4.

In each U-shaped opening 14, the area defined by the distance L serves as a guide area for guiding the solder tail onto the connection land portion 18a.

The detailed configuration of the U-shaped openings 14, the distance L of the guide areas, the array of connection land portions 18a, etc., are determined depending upon the configuration and array of the solder tails of the connector. Thus Figs. 4 and 5 represent the connection land portions 18a and U-shaped openings 14, for a staggered array of tails and to a single non-staggered row of tails respectively.

Mounting the connector on the printed circuit board constructed as set out above will be explained below in more detail.

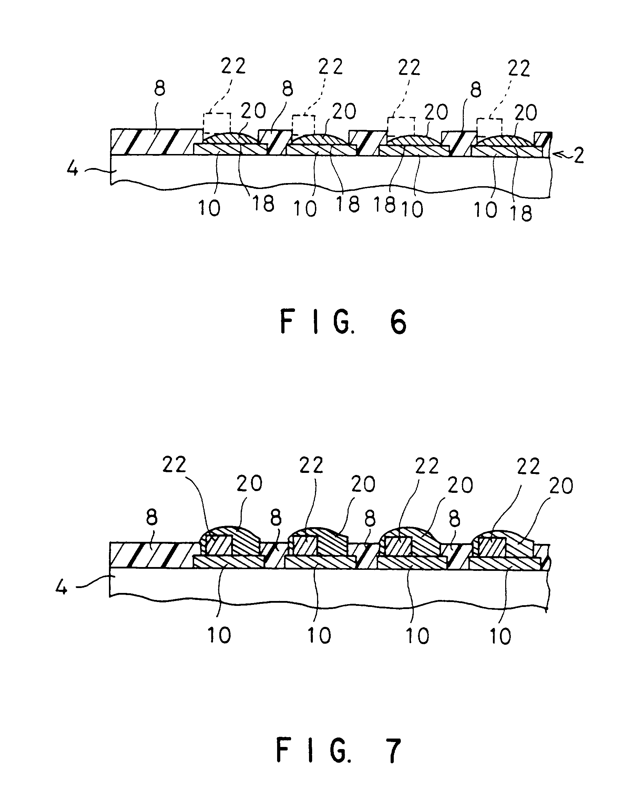

As shown in Fig. 6 a solder paste 20 is printed on the solder pad exposed portions 18 in the U-shaped openings 14 prior to a soldering step. Given that the thickness of the solder mask layer 8 is, for example, about 4 mils, the thickness of the solder paste 20 is set to be about 2 to 34 mils.

Tin-plated solder tails are employed as the solder tails 22 of the contacts of the connector which is to be connected to the connection land portion 18a (see Figs. 4 and 5) of the solder pad 10. Prior to the soldering step, each solder tail 22 is inserted onto the associated connection land portion 18a in the U-shaped opening 14. That is, the forward end of the solder tail 22 is inserted onto the opening 14 via the edge 4a of the laminated board 4 and hence guided onto the connection land portion 18a along one side edge of the U-shaped opening 14.

Since the U-shaped opening 14 serves as a guide area for guiding the solder tail 22 of the connector onto the connection land portion 18a, it is easy to properly orient the solder tail relative to the connection land portion 18a even if the solder tails 22 are arranged as a fine pitch array. Further, any misalignment can be avoided between the solder tail 22 and the connection land portion 18a upon soldering.

As shown in Fig. 7, the solder tails 22 the connection land portions 18a of the solder pads 10 which are oriented in their position are soldered by, for example, a reflow type automatic soldering apparatus so that they are electrically and mechanically connected to each other.

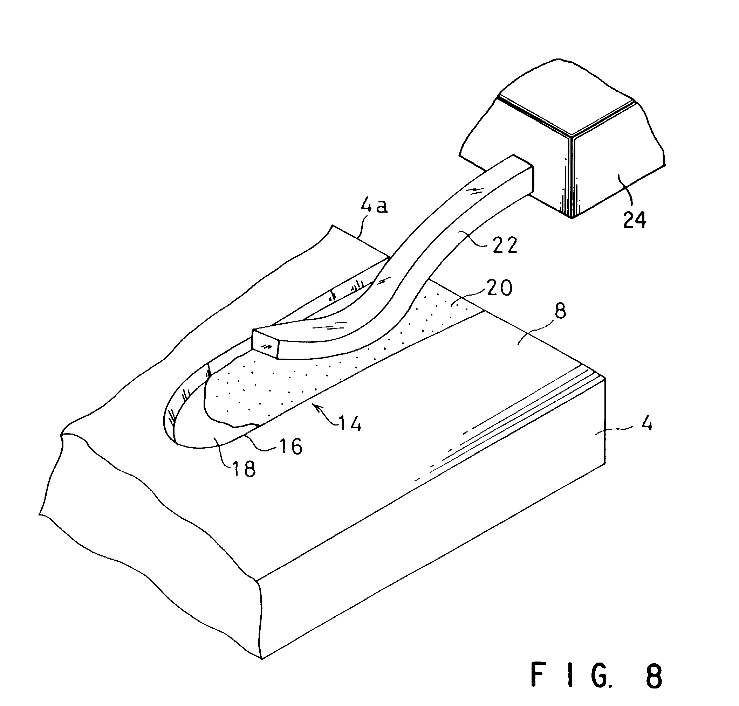

Alternatively, as shown in Fig. 8, the solder paste 20 may be coated onto the solder pad exposed portions 18 and, in this case, the solder tails 22 may be soldered to the connection land portion 18a manually.

In any case, molten solder 26 in the respective U-shaped opening 14 is dammed up by the inner wall 16 of the U-shaped opening 14. It is thus possible to prevent leakage of the molten solder into the adjacent U-shaped openings and to prevent the formation of a solder bridge or bridges which might cause a short-circuiting between the adjacent solder tails 22.

Although the present invention has been explained as being one embodiment, it is not restricted to this embodiment. For example, the details of the solder pad 10, such as its configuration, are not restricted to the ones illustrated and explained above.

## Claims

1. A printed circuit board (2) for electrically connecting to a connector (24) having a plurality of contacts (22), comprising:
a laminated board (4);
a conductive printed circuit pattern layer (6,12) provided over a surface of the laminated board (4), said circuit pattern layer also defining a plurality of separate solder pads (10) intended for soldering to the contacts (22) and
a solder mask layer (8) partly covering the circuit pattern layer (6) and the solder pads (10);
characterised in that
the solder mask layer (8) has openings (14) facing an edge (4a) of the board (4) and corresponding to the solder pads (10) to create exposed portions (18) of the solder pads (10) and the solder mask layer covers all the edge surfaces (l0b, 10c, l0d) of the solder pads (10) except for the edge surfaces (10a) adjacent the edge (4a) of the board (4) and the exposed portions (18) of the solder pads (10) alternate with portions of the solder mask layer (8), along said one edge (4a) of said laminated board (4).

2. A printed circuit board (2) according to claim 1 wherein the exposed portions (18) of the solder pads (10) include a plurality of connection
land portions (18a) each spaced at a pre-determined distance from the edge (4a) of the laminated board (4).

3. A printed circuit board according to claim 2, wherein the connection land portions (18a) are spaced from the edge (4a) of the board by the same predetermined distance (Figure 5).

4. A printed circuit board according to claim 2, wherein the connection land portions (18a) are spaced from the edge (4c) of the board by first and second alternating pre-determined distances (Figure 4).

5. A printed circuit board according to any one of claims 1 to 4, wherein the openings (14) in the solder mask layer (8) are U-shaped.

## Patentansprüche

1. Gedruckte Leiterplatte (2) zum elektrischen Verbinden mit einem Verbinder (24), welcher eine Mehrzahl von Kontakten (22) aufweist, umfassend:
eine laminierte Platte (4),
eine leitfähige gedruckte Schaltungsmusterschicht (6, 12), welche auf einer Oberfläche der laminierten Platte (4) vorgesehen ist, wobei die Leitungsmusterschicht ferner eine Mehrzahl von separaten Lötkonsolen (10) bildet, die zum Verlöten mit den Kontakten (22) vorgesehen sind, und
eine Lötmaskenschicht (8), welche teilweise die Schaltungsmusterschicht (6) und die Lötkonsolen (10) bedeckt, dadurch gekennzeichnet,
daß die Lötmaskenschicht (8) Öffnungen (14) aufweist, welche zu einem Rand (4a) der Platte (4) weisen und den Lötkonsolen (10) entsprechen, um freiliegende Abschnitte (18) der Lötkonsolen (10) zu erzeugen, und daß die Lötmaskenschicht alle Randoberflächen (10b, 10c, 10d) der Lötkonsolen (10) bedeckt mit Ausnahme der Randoberflächen (10a) benachbart dem Rand (4a) der Platte (4), und daß die freiliegenden Abschnitte (18) der Lötkonsolen (10) sich mit Abschnitten der Lötmaskenschicht (8) entlang des einen Randes (4a) der laminierten Platte (4) abwechseln.

2. Gedruckte Leiterplatte (2) nach Anspruch 1, worin die freiliegenden Abschnitte (18) der Lötkonsole (10) eine Mehrzahl von Verbindungsflächenabschnitten (18a) umfassen, welche jeweils mit einem vorbestimmten Abstand von dem Rand (4a) der laminierten Platte (4) entfernt angeordnet sind.

3. Gedruckte Leiterplatte nach Anspruch 2, worin die Verbindungsflächenabschnitte (18a) von dem Rand (4a) der Platte mit dem gleichen vorbestimmten Abstand entfernt angeordnet sind (Figur 5).

4. Gedruckte Leiterplatte nach Anspruch 2, worin die Verbindungsflächenabschnitte (18a) von dem Rand (4c) der Platte mit ersten und zweiten alternierenden vorbestimmten Abständen entfernt angeordnet sind (Figur 4).

5. Gedruckte Leiterplatte nach einem der Ansprüche 1 bis 4, worin die Öffnungen (14) in der Lötmaskenschicht (8) U-förmig sind.

## Revendications

1. Plaque de circuit imprimé (2) pour connexion électrique sur un connecteur (24) ayant une pluralité de contacts (22) comprenant :
- une plaque stratifiée (4) ;
- une couche conductrice de configuration de circuit imprimé (6, 12) prévue au-dessus d'une surface de la plaque stratifiée (4), ladite couche de configuration de circuit délimitant également une pluralité de plots de soudure séparés (10) destinés au soudage des contacts (22) et,
- une couche de masque de soudure (8) recouvrant partiellement la couche de configuration de circuit (6) et les plots de soudure (10) ;
caractérisée en ce que :
la couche de masque de soudure (8) possède des ouvertures (14) faisant face à une arête (4a) de la plaque (4) et correspondant aux plots de soudure (10) pour créer des portions dégagées (18) des plots de soudure (10) et la couche de masque de soudure recouvre toutes les surfaces d'arêtes (10b, 10c, 10d) des plots de soudure (10), à l'exception des surfaces d'arêtes (10a) adjacentes à l'arête (4a) de la plaque (4) et des portions dégagées (18) des plots de soudure (10) alternés aux portions de la couche de masque de soudure (58), le long de ladite arête (4a) de ladite plaque stratifiée (4).

2. Plaque de circuit imprimé (2) selon la revendication 1 dans laquelle les portions exposées (18) des plots de soudure (10) comportent une pluralité de portions de cloisons de raccordement (18a) chacune espacée d'une distance prédéterminée de l'arête (4a) de la plaque stratifiée (4).

3. Plaque de circuit imprimé selon la revendication 2, dans laquelle les portions de cloison de raccordement (18a) sont espacées de l'arête (4a) de la plaque de la même distance prédéterminée (figure 5).

4. Plaque de circuit imprimé selon la revendication 2 dans laquelle les portions de cloison de raccordement (18a) sont espacées de l'arête (4c) de la plaque selon des première et seconde distances alternées prédéterminées (figure 4).

5. Plaque de circuit imprimé selon l'une quelconque des revendications 1 à 4, dans laquelle les ouvertures (14) de la couche de masque de soudure (8) sont en forme d'U.
